Europäisches Patentamt

European Patent Office

Office européen des brevets

(11) Publication number: **0 412 326 A2**

# EUROPEAN PATENT APPLICATION

(21) Application number: **90113668.9**

(22) Date of filing: **17.07.90**

(51) Int. Cl.5: **G03F 7/38**

(30) Priority: **10.08.89 IT 2149689**

(43) Date of publication of application:
**13.02.91 Bulletin 91/07**

(84) Designated Contracting States:
**DE FR GB NL SE**

(71) Applicant: SGS-THOMSON
MICROELECTRONICS s.r.l.
Via C. Olivetti, 2
I-20041 Agrate Brianza Milano(IT)

(72) Inventor: **Degiorgis, Giorgio**
Via Ferrario, 65
I-20041 Agrate Brianza (Milan)(IT)

(74) Representative: **Perani, Aurelio et al**
c/o JACOBACCI-CASETTA & PERANI S.p.A 7,
Via Visconti di Modrone
I-20122 Milano(IT)

(54) **A high-resolution lithographic method of making monolithic integrated circuits.**

(57) A high-resolution lithographic method of making monolithic integrated circuits, being of a type wherein a silicon wafer is exposed to an electromagnetic radiation of predetermined wavelength following the interposition of a light mask, to photochemically generate, in first areas of the film, acid compounds from light-sensitive compounds, provides for selective removal of said first areas of the film following neutralization of the acid compounds, exposing second areas of the film, incorporating silicon to the last mentioned areas, developing by means of oxygen plasma to form, on the second areas of the film, a protective layer of silicon dioxide and selectively removing the remaining areas. This method enables the definition with high yield on the wafer of structures smaller than one micron.

This invention relates to a high-resolution lithographic method of making monolithic integrated circuits, which comprises the preliminary steps of applying, onto a silicon wafer, a film of a polymeric material incorporating at least one light-sensitive compound, and exposing first areas of the film to an electromagnetic radiation to photochemically generate in a surface layer thereof acid compounds from said light-sensitive compounds.

As is known, a monolithic integrated circuit is basically comprised of a small sheet of a semiconductor material, the so-called "wafer", wherein the various circuit components are formed as a series of superimposed layers or connection levels.

At each of the wafer connection levels, the arrangement of the various circuit elements is defined by means of a lithographic process whereby the pattern or "geometry" of the circuit, as previously defined on a glass sheet or light mask, is transferred onto the wafer.

During an initial step of this lithographic process, the wafer is coated with a film of light-sensitive polymer or photoresist having a thickness dimension of about 1 micron.

The photoresist coated wafer is then exposed, with the interposition of the light mask, to a radiation having a predetermined wavelength effective to produce phisico-chemical alterations in the exposed polymer.

As is known, such physico-chemical changes should allow subsequent selective removal of predetermined areas of the photoresist, such as the areas exposed to the radiation, from the wafer surface.

This subsequent step of selective removal of the photoresist is customarily referred to in the art by the term "development". The latter may be either carried out in a "wet" condition by using suitable liquid reactants, or in a "dry" condition by using suitably ionized, gaseous reactive species.

It is only after the photoresist has been developed that a reproduction of the pattern previously defined on the light mask can be obtained.

In connection with the lithographic processes employed in the production of a monolithic integrated circuit, the need arises to reproduce on the wafer geometries of ever smaller size, while ensuring low-fault features for the overall process.

It is a recognized fact that meeting such a demand is made difficult by the concurrence of a number of factors, all equally important and often conflicting with one another.

A first significant factor entering the definition of ever smaller structures on the wafer is tied to the well-recognized difficulty of optically resolving geometries of a size smaller than 1 micron.

The optical resolution of such small geometries actually often constitutes a problem where the wafer layer coated with the photoresist presents steps and hollows as are typical of a microelectronic circuit or part thereof.

A second factor in the aforesaid problem is tied to the difficulty of selectively removing, as faultlessly as feasible, predetermined areas of the photoresist, such as those exposed to the radiation.

In a attempt to meet the above-noted demand, the specific prior art has proposed lithographic methods wherein the photoresist is developed in a dry condition by means of an ionized gas plasma comprising oxygen ions as the active species.

More particularly, in order to define geometries smaller than 1 micron on the photoresist, the prior art provides for the use of multi-layered photoresists comprising a first resin layer adapted to evenly cover the topography of the underlying circuit, levelling out any steps therein (planarizing layer), and second surface layer of a light-sensitive resin intended for exposure to the light radiation.

While this technique has actually enabled reproduction on the wafer of structures of a size below 1 micron, it has so far failed to gain practical acceptance by the industry on account of its complexity making it difficult to control and being liable to a high rate of faults.

A major consequence of this high rate of faults or rejects, to the point of making such prior technique impractical, is the large number of faulty circuits yielded, which circuits must be discarded of necessity.

Some examples of lithographic methods employing multi-layer resins are illustrated by Wilkins et al. in J. Vac. Sci. Technol. B3 (1), 306-309, (1985), Shaw et al. in Solid State Tech., June 1987, 83-89 (1987), and McColgin et al. in Symp. VLSI Tech., Digest of Technical Papers, 9-10 (1987).

A further lithographic method developed by the pertinent prior art, and referred to as "image reversal", provides for the use of a single planarizing layer of photoresist which is exposed, in selected areas thereof defined by a light mask, to a radiation having a predetermined wavelength.

In the exposed areas, where the light will promote formation of acid compounds, basic compounds, which comprise silicon, are then caused to diffuse for incorporation into the photoresist.

Thereafter, the photoresist in dry developed using an oxygen plasma which will selectively remove the areas without silicon and form a protective layer of $SiO_2$ on the remainder containing it.

Investigation and research work carried out on the matter has, however, brought out that the selectivity of silicon diffusion between exposed and unexposed areas is difficult to control, which results in the formation of undesired residues during the plasma developing.

These residues, besides adding to the method a higher rate of rejects, prevent reduction of the resolution to a value below 1 micron as aimed at.

Some examples of the aforesaid image-reversal lithographic methods are illustrated by Roland et al., SPIE Proceedings 771, 69 (1987), Brust et al., SPIE Proceedings 920, 260 (1988), and Spencer et al., SPIE Proceedings 920, 295 (1988).

The technical problem that underlies this invention is to provide a lithographic method of making monolithic integrated circuit which can define, on a silicon wafer, patterns of a size equal to 1 micron or lower, and at the same time have a low rate of rejects.

This problem is solved according to the invention by a method as indicated being characterized in that it comprises the steps of:

(a) neutralizing the photochemically generated, acid compounds with a low molecular weight basic compound;

(b) exposing second areas, previously unexposed of, of the film to photochemically generate said acid compounds in a surface layer thereof;

(c) diffusing a silicon-containing basic molecule through said surface layer including said acid compounds; and

(d) removing the silicon-free areas of the film using oxygen plasma to define structure having a predetermined geometry on the wafer.

According to an aspect of this invention, during said photoresist exposure steps, which are carried out with and without the interposition of a light mask, respectively, the photochemically generation of said acid compounds only takes place within a surface layer of limited depth, on the order of 200 to 1000 Angstrom, of the polymeric material or photoresist.

In this way, a sufficient thickness of photoresist can be used to level out the topography of the underlying circuit.

The net result is the advantageous ability to resolve structures of a smaller size than 1 micro without focusing problems from the presence of steps in the photoresist.

Of the viable photoresist, those employing a novolac as the base resin are preferred. Resists currently employed comprise a solvent (acetates, ethyl-lactate, etc.), a resin (novolac) and a light-sensitive element (diazo-naphthoquinone).

Illustratively, the following are suitable alternative resins:
polymethyl-methacrylate,
polymethyl-isopropenyl-ketone,
poly(butene-1-sulphone),
poly(styrene-sulphone).

The light-sensitive compounds incorporated into the polymeric material film are selected from a group having for its base molecule that of quinone, but the substituents may be of varying nature.

Among these, the following are preferred: 1,2,5- and 1,2,4-diazo-naphtho-quinone, such as the commercially available compounds known as McDermid Ultramac EPA-914-30, Olin-Hunt HPR-504, or McDermid Ultramac PR-1024-MB-628.

The above-listed light-sensitive compounds are converted into corresponding indene-carboxylic acid compounds on exposure to a wavelength in the 365 to 436 nanometers range.

The photoresist is preferably subjected to 70-90 successive exposures, each lasting 100-500 ms, at temperature of about 25° C. Specifically, during each exposure, two or three devices will be defined by the light mask, each occupying different areas of predetermined size on the wafer. On completion of the exposure steps, there will be defined thereby on the wafer 140 to 270 devices.

Therefore said neutralization of these acid compounds is accomplished after diffusing through the photoresist film basic compounds having a low molecular weight. Among the latter, low molecular weight amines such as ammonia, methylamine, mono- or diethylamine, and halogenated derivatives thereof are the preferred ones.

The temperatures and times for the neutralization step may be selected within the ranges of 60° to 100° C and 35 to 50 minutes, respectively.

By this neutralization step, in the method of this invention, a double image reversal takes place; in fact the areas first exposed to light, i.e. the areas unprotected by the light mask, are the ones that will be removed during the final step of the development with oxygen plasma.

In accordance with an aspect of this invention, the incorporation of silicon to the photoresist is only performed after neutralizing, in said surface layer, the acid compounds generated during exposure.

In order to favor the diffusion of silicon through the photoresist, and its incorporation thereto, the photoresist is once again exposed to light so as to form the aforesaid acid compounds in a surface layer of the previously unexposed areas. The acid compound will react, during the next method step, with a basic molecule comprising silicon, following diffusion thereof through the photoresist film. Among the basic molecules employed, trimethylchlorosilane (TMCS) and hexamethyl-disilazane (HMDS) are preferred.

The diffusion step of these basic molecules through the photoresist or silylation takes place -- contrary to what the prior art makes possible -- in a highly selectively manner. It cannot take place, in fact, where the neutralization products, low molecular weight amine/acid compound, are present. Where the acid compound is indenecarboxylic acid, this neutralization product would be indene.

In a like manner as in the previous exposure step, silylation of the photoresist will only affect a surface layer thereof in the 200 to 1000 Angstrom range.

The working conditions for silylation are a temperature within the range of 100° to 180°C, a pressure in the 5 to 30 Torr range, and a duration in the 2 to 50 minutes range.

The final step of dry developing the photoresist takes place under the customary conditions, well-known in the art, for RIE (Reactive Ion Etcher) or MIE (Magnetron Ion Etcher) development techniques.

Preferred are pressures within the range of 50 to 150 mTorr, and development times in the 2 to 5 minutes range. During development, the temperature is instead maintained at ambient levels (approximately 25°C).

It should be noted that, whereas the areas exposed first are thoroughly removed, the areas incorporating silicon are protected by a layer of $SiO_2$ generated by the oxygen plasma itself.

The method of this invention thus enables, advantageously and contrary to what the prior art could afford, an almost complete utilization of the selective etching properties of development by plasma.

Further features and advantages of the method according to the invention will become apparent from the following detailed description, of a preferred, but not exclusive, embodiment thereof, given by way of non-limitative example.


EXAMPLE


A set made up of twenty five silicon wafers were subjected, using conventional techniques, to coating with a novolac-based resist to yield a film approximately 2.2 micron thick. The photoresist employed incorporated 1,2,4-diazo-naphthoquinone as the light-sensitive compound.

The wafers were then introduced into an exposer ASML 2500 I-line Stepper, and exposed, one at a time, to an electromagnetic radiation at a wavelength of about 365 nm following interposition of an appropriate light mask including the image of two devices. More specifically, each wafer was subjected to seventy successive exposure frames to transfer a total of 140 devices onto the entire surface of the wafer. Each exposure had a duration time of about 250 ms. The temperature and pressure within the exposing apparatus where maintained under ambient conditions (25°C, 1 atm).

The wafers where then moved to a decarboxylation apparatus, Model SMI from Y.E.S. (Yield Engineering System), where the photochemically generated indenecarboxylic acid was neutralized with ammonia.

To this end, the wafers were maintained at a temperature of 80°C and a pressure of about 3 Torr for approximately 45 minutes in an environment saturated with ammonia vapors.

Thereafter, the wafers were taken out and their surface again exposed, this time with no intervening light mask, to an electromagnetic radiation having a wavelength of from 300 to 400 nm (broad band). For this purpose, the exposing apparatus employed was a Model Autoflood 1000 from OAI (Optical Associate Instrument).

During this second exposure, for an overall duration time of about 130 seconds, the temperature and pressure were maintained at ambient conditions.

The wafers, thus processed and incorporating indenecarboxylic acids in the exposed areas, were then introduced into a silylation module by SVG (Silicon Valley Group), Model 86 XX, in order to have silicon incorporated to said areas of the photoresist film.

The basic molecule used for diffusion was hexamethyl-disilazane fed continuously into a module PSVG (Primer Silicon Valley Group) for silylation at a volume flow rate of about 13 cubic centimeters per minute. The temperature and pressure were controlled at 150°C and 10 Torr, respectively, during silylation. The overall silylation time was of about 2 minutes.

The silicon wafers were then taken, for the final development step, to a developing apparatus, Model Tegal 1511, wherein an oxygen plasma was generated using RF at about 13.56 MHz.

An oxygen volume flow rate of 5 $cm^3$/min was fed into this apparatus, and the temperature and pressure were held at about 25°C and about 100 mTorr, respectively. The photoresist development was completed in about 2 minutes.

On completion of the lithographic process, the wafers were checked to find out possible faults and ascertain that the degree of resolution sought had been achieved.

The method described hereinabove enabled a structure of 0.7 microns in size to be transferred onto the wafers. Out of a total of twenty five wafers, each including 140 devices, about 50% of the devices were found to be free of faults and passed on for further processing.

Thus, the method of this invention has proved to be uniquely suitable to provide for reproduction of structures measuring less than one micron in size on wafers, at a low rate of rejects. In fact, the output of faultless devices can be as high as 50% approximately, as against the levels of 30-40% afforded by lithographic methods according to prior art tecniques.

## Claims

1. A high-resolution lithographic method of making monolithic integrated circuits, including the preliminary steps of applying, onto a silicon wafer, a film of polymeric material incorporating at least one light-sensitive compound and exposing first areas of the film to an electromagnetic radiation to photochemically generate in a surface layer thereof acid compounds from said light-sensitive compounds, characterized in that it comprises the steps of:

(a) neutralizing said photochemically generated, acid compounds with a low molecular weight basic compound;

(b) exposing second areas, previously unexposed, of the film to photochemically generate said acid compounds in a surface layer thereof;

(c) diffusing a silicon-containing basic molecule through said surface layer including said acid compounds; and

(d) removing said first areas of the film using oxygen plasma to define a pattern having a predetermined geometry on the wafer.

2. A method according to Claim 1, characterized in that said low molecular weight basic compounds are selected from a group including ammonia, methylamine, mono-ethylamine, di-ethylamine, and halogenated derivatives thereof.

3. A method according to Claim 1, characterized in that said light-sensitive compounds are selected from a group including 1,2,5- and 1,2,4-diazo-naphthoquinone.

4. A method according to Claim 1, characterized in that said silicon-containing basic molecule is selected from a group including trimethylchlorosilane and hexamethyldisilazane.

5. A method according to Claim 1, characterized in that said electromacnetic radiation has a wavelength within the range of 365 to 436 nanometers.

6. A method according to Claim 1, characterized in that said step (b) of exposing said second areas of the polymeric material film is carried out at an ambient temperature and for an exposure time of 100-500 ms.

7. A method according to Claim 1, characterized in that said neutralization step is carried out at a temperature of from 60° to 100° C and for a time of from 35 to 50 minutes.

8. A method according to Claim 1, characterized in that said step of diffusing a silicon-containing basic molecule through said surface layer of said second areas is carried out at a temperature of 100-180° C, a pressure of 5-30 Torr, and for a time of from 2 to 50 minutes.

9. A method according to Claim 1, characterized in that said step of removing said first silicon-free areas of the film is carried out at a temperature of 100-150° C, a pressure of 5-30 Torr, and for a time of 2-50 minutes.

10. A method according to Claim 1, characterized in that said surface layer including said acid compounds has a thickness within the range of 200 to 1000 Angstrom.